# EUROPÄISCHE PATENTSCHRIFT

(11) **EP 2 630 648 B1**
(45) Veröffentlichungstag und Bekanntmachung des Hinweises auf die Patenterteilung: **18.07.2018**
(21) Anmeldenummer: 11770748.9
(22) Anmeldetag: 13.10.2011
(51) Int. Cl.: H01F 17/06, H01F 27/33, H04B 15/02, H05K 9/00

(54) **EINRICHTUNG ZUM ABSORBIEREN DES RAUSCHENS**
DEVICE FOR ABSORBING NOISE
DISPOSITIF POUR ABSORBER UN BRUISSEMENT

(30) Priorität: 21.10.2010 DE 102010042743
(43) Veröffentlichungstag der Anmeldung: 28.08.2013
(73) Patentinhaber: Würth Elektronik eiSos GmbH & Co. KG, 74638 Waldenburg (DE)
(72) Erfinder: KONZ, Oliver, 74532 Ilshofen (DE)
(74) Vertreter: Patentanwälte Ruff, Wilhelm, Beier, Dauster & Partner mbB
(86) Internationale Anmeldenummer: PCT/EP2011/067886
(87) Internationale Veröffentlichungsnummer: WO 2012/052351

(56) Entgegenhaltungen:
- EP-B1- 0 981 856
- DE-A1- 10 014 675
- DE-A1- 10 326 685
- DE-A1- 19 811 072
- JP-A- 2006 147 796
- US-A1- 2007 120 635

## Beschreibung

Die Erfindung betrifft eine Einrichtung zum Absorbieren des elektrischen Rauschens auf Leitungen.

Es ist bekannt, dass auf elektrischen Leitungen hochfrequente Störungen übertragen werden, die zu Störungen des Arbeitens von elektronischen Geräten führen können. Diese hochfrequenten unregelmäßigen Störungen werden als Rauschen bezeichnet.

Es ist ebenfalls bekannt, dass man um die Leitungen herum Ringe aus magnetischem oder ähnlich wirkendem Material, insbesondere Ferrite, anordnen kann, die in der Lage sind, diese elektrischen Störungen zu absorbieren. Dabei gibt es je nach dem Frequenzbereich geschlossene Ringe, die zur nachträglichen Anbringung aus zwei Teilen bestehen, die dann um das Kabel herum angeordnet und so aufeinander zu beaufschlagt werden, dass sich ihre einander zugewandten Flächen lückenlos berühren. Es gibt Federbeaufschlagungen, um Luftspalte zu vermeiden. Es gibt auch Fälle, insbesondere bei höheren Frequenzen, bei denen zwischen den beiden Teilen ein definierter Luftspalt vorhanden sein soll. Auch in diesem Fall werden die beiden Ferritelemente aufeinander zu beaufschlagt, um den Luftspalt definiert einhalten zu können. Die Ferritelemente sind in Gehäuseschalen untergebracht, wobei man aus Praktikabilitätsgründen zwei Halbschalen verwendet.

Bei einer bekannten Einrichtung dieser Art sind an den Halbschalen, in denen die Ferrite untergebracht sind, kurze Stege angeformt, die beim Zusammensetzen der beiden Halbschalen zur Bildung des geschlossenen Gehäuses zwischen den einander zugewandten Stirnflächen der Ferrite zu liegen kommen und dadurch die Dicke eines Luftspalts definieren (DE 10326685). Damit nach dem Anbringen eines solchen Absorbers dieser nicht mehr von dem Kabel gelöst werden kann, ist eine Verriegelungseinrichtung vorgesehen, die bei geschlossenem Gehäuse in einer Seitenwand einer Halbschale angeordnet und von außen nicht erkennbar ist. Bei einer weiteren Einrichtung dieser Art (EP 981856) ist die Verriegelungseinrichtung ebenfalls in einer Ausnehmung der Wand einer Halbschale angeordnet und nach außen hin nicht sichtbar. Zum Öffnen gibt es ein Spezialwerkzeug, das die Verriegelung wieder öffnen kann.

Es hat sich herausgestellt, dass beim Anbringen einer solchen Einrichtung nicht immer sichergestellt werden kann, dass die Verriegelungseinrichtung vollständig eingerastet ist, so dass es zu nicht ausreichenden Ergebnissen beim Absorbieren des Rauschens kommen kann. Diese verringerte Leistungsfähigkeit wird aber erst im Gebrauch festgestellt.

Der Erfindung liegt die Aufgabe zu Grunde, eine Möglichkeit zu schaffen, den korrekten Zustand der Verriegelung unmittelbar nach dem Verriegeln überprüfen zu können.

Bei einer weiteren bekannten Vorrichtung greifen zur Verriegelung Vorsprünge in Fenster des Gehäuses ein. Das Fenster ist Teil der Verriegelungseinrichtung (US 2007/0120635 A1).

Bei einer ähnlichen Vorrichtung sind ebenfalls Durchbrechungen in der Gehäusewand vorhanden, hinter deren Stufe der Vorsprung einer Verriegelungsnase eingreift (DE 198 11 072 A1). Auch hier ist die Durchbrechung Teil der Verriegelungseinrichtung.

Eine ähnliche Lösung für eine Verriegelungseinrichtung ist bei einem Störungsdämpfer bekannt (DE 100 14 675 A1).

Zur Lösung dieser Aufgabe schlägt die Erfindung eine Einrichtung zum Absorbieren des elektrischen Rauschens mit den im Anspruch 1 genannten Merkmalen vor. Weiterbildungen der Erfindung sind Gegenstand von Unteransprüchen.

Die von der Erfindung vorgeschlagene Einrichtung enthält also eine Verriegelungseinrichtung, die im geschlossenen Zustand vollständig in einer Seitenwand einer Halbschale oder beider Halbschalen angeordnet ist. Kein Teil der Verriegelungseinrichtung ragt über die äußere Oberfläche des Gehäuses nach außen hinaus. Es kann also nicht bei der Montage an dem gegenüber dem elektronischen Rauschen zu schützenden elektronischen Gerät oder bei einer unachtsamen Handhabung der Fall auftreten, dass sich die Verriegelungseinrichtung dadurch löst. Durch die in der Wand angeordnete Durchbrechung, die man auch als Fenster bezeichnen kann, ist es möglich, die beiden miteinander zusammenwirkenden Teile der Verriegelungseinrichtung optisch zu überprüfen. Insbesondere wird es möglich, diese Überprüfung automatisch durchführen zu lassen, indem eine Kamera ein Bild innerhalb der Durchbrechung mit einem Sollbild vergleicht. Auf diese Weise lässt sich unmittelbar nach dem Anbringen eines solchen Absorbers an der Leitung in dem elektronischen Gerät oder an der zu dem elektronischen Gerät führenden Leitung überprüfen, ob die Verriegelungseinrichtung eingerastet ist und damit das Gerät geschützt ist. Es ist nicht mehr erforderlich, das Gerät in Betrieb zu nehmen.

In Weiterbildung der Erfindung kann vorgesehen sein, dass die Verriegelungseinrichtung derart ausgebildet ist, dass sie beim Schließen des Gehäuses durch den Schließvorgang betätigt wird. Dies kann beispielsweise dadurch erreicht werden, dass ein Verriegelungselement beim Auftreffen auf ein Gegenelement zunächst verformt wird, bis es nach Überwinden einer Schwelle einrastet. Wenn es widerhakenförmig gebildet ist, ist damit ein Öffnen ohne Werkzeug ausgeschlossen. Beispielsweise kann in Weiterbildung vorgesehen sein, dass die Verriegelungseinrichtung einen an einer Längskante der einen Gehäusehalbschale angeordneten Rastvorsprung und eine an der anderen Gehäusehalbschale angeordnete Rastschulter aufweist, hinter die der Rastvorsprung oder ein Teil des Rastvorsprungs in geschlossenem Zustand des Gehäuses eingreift. Diese Position des Rastvorsprungs unterscheidet sich von der nicht eingerasteten Position des Rastvorsprungs in optisch wahrnehmbar Weise, so dass auch eine Kamera diesen Unterschied erkennen kann.

In nochmaliger Weiterbildung der Erfindung kann vorgesehen sein, dass die Rastschulter, also der Teil, hinter den der Rastvorsprung eingreift, in einer Vertiefung der Wand der Gehäusehalbschale angeordnet ist. Diese Vertiefung mündet in der Längskante der Halbschale, die in geschlossenem Zustand des Gehäuses auf einer Längskante der anderen Halbschale liegt.

Die Ausnehmung kann gegebenenfalls zur Innenseite des Gehäuses offen sein. Zur Außenseite des Gehäuses ist sie durch die Durchbrechung geöffnet, wobei die Durchbrechung kleiner sein kann als die Ausnehmung selbst.

Die Vertiefung kann in Weiterbildung derart ausgebildet sein, dass sie eine Führung für den an der gegenüberliegenden Längskante der anderen Gehäusehalbschale ausgebildeten Rastvorsprung bildet.

In nochmaliger Weiterbildung der Erfindung kann das Gehäuse der Einrichtung eine in der Oberfläche eine der Halbschalen mündende Öffnung zum Einsetzen eines Werkzeugs aufweisen, mit dessen Hilfe die Verriegelungseinrichtung außer Eingriff gebracht werden kann. Die Öffnung steht also mit der Ausnehmung in Verbindung, in der die Rastschulter angeordnet ist.

Da die in den Gehäusehalbschalen untergebrachten Ferrite je nach Anwendungsfall auch eine beachtliche Länge aufweisen können und über ihre gesamte Länge entweder aneinander anliegen sollen oder aber über die gesamte Länge einen konstanten Luftspalt aufweisen müssen, kann erfindungsgemäß vorgesehen sein, dass eine Verriegelungseinrichtung an zwei oder mehr in Längsrichtung des Gehäuses einen Abstand aufweisenden Stellen wirksam ist, indem beispielsweise an zwei Stellen jeweils ein Rastvorsprung und eine Rastschulter ausgebildet ist. Dabei ist die Durchbrechung an beiden Stellen vorhanden, um das korrekte Verriegeln auch an beiden Stellen überprüfen zu können.

Zum Zusammensetzen zweier Halbschalen zur Bildung eines Gehäuses und zum Zusammenfassen der Ferritelemente kann vorgesehen sein, dass die beiden Halbschalen getrennt hergestellt sind und im Bereich beider Längskanten jeweils eine Verriegelungseinrichtung aufweisen. Erfindungsgemäß kann jedoch bevorzugt in Weiterbildung vorgesehen sein, dass die beiden Gehäusehalbschalen an ihrer einen Längskante mithilfe eines Filmscharniers miteinander verbunden sind. Die Verriegelungseinrichtung befindet sich dann an den jeweils anderen Längskanten des Gehäuses.

Zur Erleichterung der Montage kann vorgesehen sein, dass an einer Gehäusehalbschale im Bereich mindestens des einen axialen Endes, also der Stelle, wo das Kabel in das Gehäuse eintritt, eine Festlegeeinrichtung zur Fixierung der Gehäusehalbschale an dem Kabel angeordnet ist. Diese Festlegeeinrichtung kann beispielsweise zwei parallele Stege aufweisen, die zwischen sich einen Abstand aufweisen, der etwas kleiner ist als der Durchmesser des vorgesehenen Kabels. Auf diese Weise lässt sich die von der Erfindung vorgeschlagene Einrichtung schon in geöffneten Zustand an dem Kabel an der gewünschten Stelle fixieren, so dass sie anschließend zugeklappt und verriegelt werden kann.

Zur weiteren Vereinfachung der Handhabung kann vorgesehen sein, dass jede Halbschale eine Einrichtung zur Festlegung eines Sanitärelements in der jeweiligen Halbschale aufweist. Es kann sich dabei um eine angeformte federnde Zunge handeln, die in einer Ausnehmung im Bereich der Stirnkante jedes Ferritelements eingreift. Diese Festlegeeinrichtung erleichtert die Montage der Einrichtung am Kabel.

Weitere bevorzugte Merkmale, Einzelheiten und Vorzüge der Erfindung ergeben sich aus den Ansprüchen, der folgenden Beschreibung bevorzugter Ausführungsformen der Erfindung sowie anhand der Zeichnung. Hierbei zeigen:
- Figur 1: eine Draufsicht auf die geöffnete Einrichtung;
- Figur 2: in geringfügig verkleinertem Maßstab eine Ansicht von der gegenüberliegenden Seite;
- Figur 3: eine Stirnansicht der geöffneten Einrichtung von links in Figur 1;
- Figur 4: einen Längsschnitt durch eine Halbschale etwa längs Linie IV bis IV in Figur 1;
- Figur 5: in vergrößertem Maßstab einen Ausschnitt aus der Figur 4;
- Figur 6: eine Seitenansicht der Einrichtung aus einer Richtung von unten in Figur 1;
- Figur 7: eine Seitenansicht der geschlossenen Einrichtung;
- Figur 8: in vergrößertem Maßstab einen Ausschnitt aus der Figur 7;
- Figur 9: in vergrößertem Maßstab das zusammenwirken der Verriegelungseinrichtung an den Längskanten zweier Halbschalen;
- Figur 10: eine Stirnansicht der geschlossenen Einrichtung;
- Figur 11: eine Draufsicht auf die geschlossene Einrichtung.

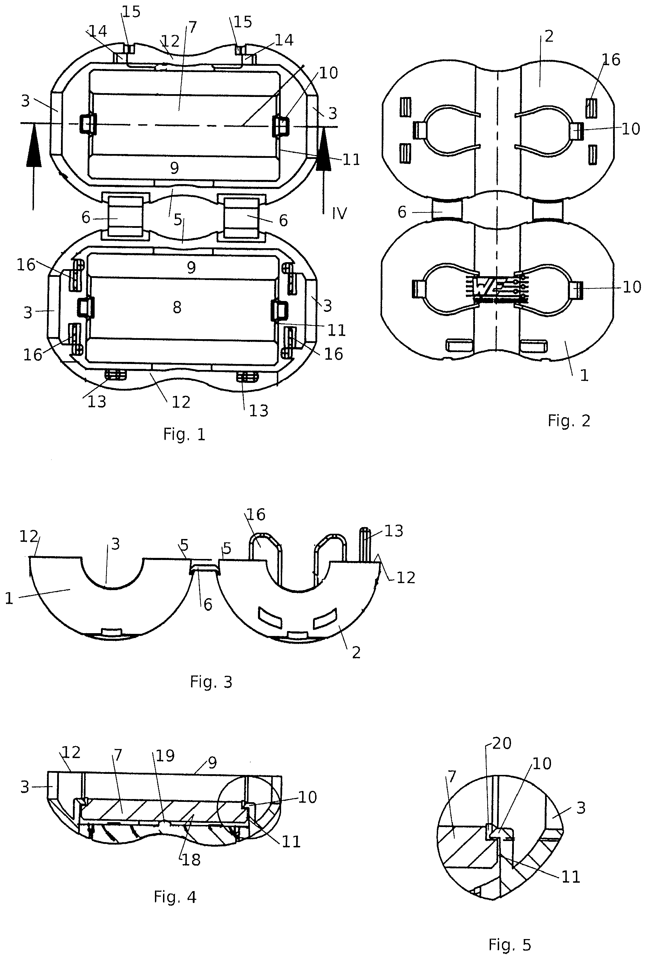

In Figur 1 sind die beiden Halbschalen 1, 2 von ihrer Innenseite her dargestellt. Die sichtbaren Kanten liegen in zusammengeklapptem Zustand dann aneinander an, um ein spaltfreies Gehäuses zu bilden. Im Bereich der beiden Stirnenden weist jede Halbschale 1, 2 je eine halbkreisförmige Aussparung 3 auf, die in zusammengeklapptem Zustand deckungsgleich liegen und eine angenähert kreisförmige Öffnung bilden. Eine Verbindungslinie 4 zwischen den Aussparungen 3 einer Halbschale 1, 2 bildet eine Längsrichtung der Halbschale 1, 2 und damit auch des Gehäuses. Im Bereich der einen Längskante 5 sind die beiden Halbschalen 1, 2 mithilfe eines Folienscharniers 6 miteinander verbunden.

In jeder Halbschale liegt ein Ferritelement 7, das die Form eines Trogs aufweist mit einer in Längsrichtung verlaufenden Nut 8 und zwei in einer gemeinsamen Ebene verlaufenden Trennflächen 9. Wenn die beiden Halbschalen 1, 2 geschlossen werden, liegen die Trennflächen 9 der beiden Ferritelemente 7 aneinander an.

Die Ferritelemente 7 werden in der jeweiligen Halbschale 1, 2 mithilfe von zwei federnden Zungen 10 festgehalten, die in Kerben an den jeweiligen Stirnseiten 11 der Ferritelemente 7 eingreifen.

An den den Längskanten 5 mit dem Filmscharnier 6 abgewandten Längskanten 12 sind Elemente einer Verriegelungseinrichtung angeordnet. An der äußeren Längskante 12 der in Figur 1 unteren Halbschale 2 sind mit Abstand in Längsrichtung zwei Rastvorsprüngen 13 ausgebildet, die über die Längskante 12 in Figur 1 gegenüber der Zeichnungsebene vorstehen. An der äußeren Längskante 13 der jeweils anderen Halbschale 1 sind an den entsprechenden Stellen von der Längskante 12 ausgehende Vertiefungen 14 ausgebildet, die nach innen hin offen sind. Zur Außenseite ist für jede Vertiefung 14 eine Durchbrechung 15 ausgebildet, die versetzt gegenüber der Vertiefung 14 ist. Beim Zusammenklappen der beiden Halbschalen um die durch das Filmscharnier 6 gebildete Achse gelangen die Rastvorsprünge 13 in die Vertiefungen 14.

Die in Figur 1 untere Halbschale, das heißt die Halbschalen mit den Rastvorsprüngen 13, weist außerhalb der Stirnseiten 11 der Ferritelemente 72 senkrecht zur Zeichnungsebene verlaufende Stege 16 auf. Diese Stege 16 sind in Längsrichtung der Halbschale gesehen zwischen der Öffnung 3 und der Stirnkante 11 des jeweiligen Ferritelements 7 angeordnet. Die Stege 16 weisen einen Abstand zwischen ihren Innenkanten auf, der etwas kleiner ist als der Durchmesser der Leitung, für die eine spezielle Einrichtung bestimmt ist.

Die Figur 2 zeigt eine Ansicht der Anordnung der Figur 1 von der gegenüberliegenden Seite in einem etwas verkleinertem Maßstab. Man kann aus der Außenseite der Halbschale 2, oben in Figur 2, sehen, dass dort die Stege 16 angeformt sind, da die Öffnungen für den Schieber des Werkzeugs, in dem die Halbschale gespritzt wird, sichtbar sind. Ebenfalls sichtbar sind die Öffnungen für die federnden Zungen 10.

Die Figur 3 zeigt die Anordnung der Figur 1 von links in Figur 1. Die beiden Halbschalen 1, 2 liegen mit ihren äußeren und inneren Längskanten 12, 5 ebenso wie mit ihren Stirnkanten 17 jeweils in einer Ebene. Die in Figur 3 rechte Halbschale 2 weist die bereits erwähnten Stege 16 auf, die zwischen sich mit ihren Innenkanten einen Schlitz mit parallelen Seitenwänden bilden. Ebenfalls zu sehen ist einer der beiden Rastvorsprünge 13 auf der äußeren Längskante 12 der einen Halbschale 2.

Der Längsschnitt durch die Halbschale 1 in Figur 4 zeigt, dass die Halbschale 1 einen innen ebenen Boden 18 aufweist, in dessen Mitte ein Vorsprung 19 angeformt ist. Auf diesem Vorsprung 19 liegt das Ferritelement 7 auf. Die beiden federnden Zungen 10, die aus dem Boden der Halbschale 1 ausgeformt sind, greifen in die erwähnten Kerben in den Stirnseiten 11 des Ferritelements 7 ein. Dadurch wird das Ferritelement 7 in der Halbschale gehaltert. Die Trennfläche 9 des Ferritelements 7 liegt in einer Ebene mit der Längskante 12 der Halbschale 1.

Dieses Eingreifen der federnden Zungen 10 in einer Ausnehmung 20 des Bodens des Ferritelements 7 ist in dem Ausschnitt in Figur 5 nochmals deutlicher dargestellt.

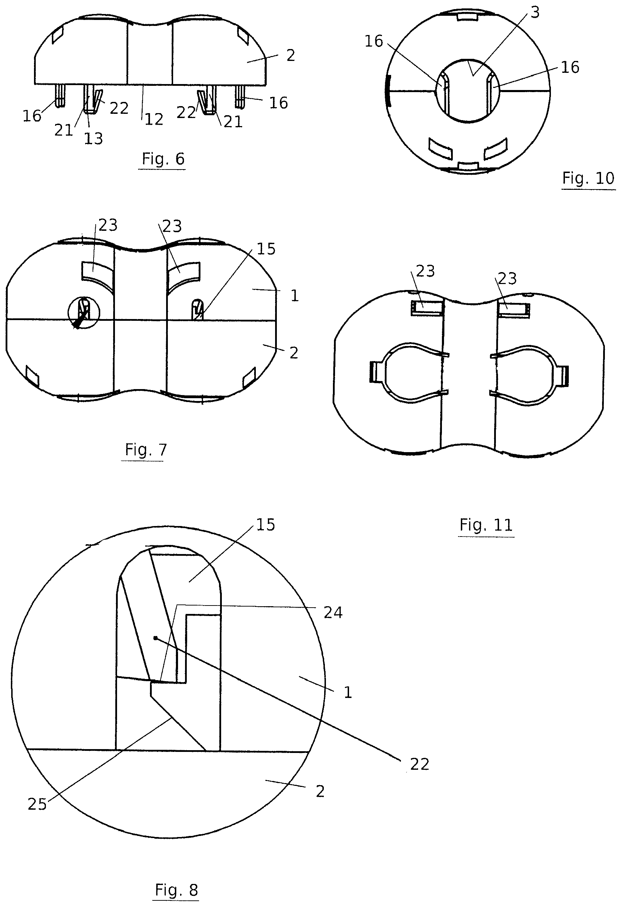

Figur 6 zeigt nun eine Seitenansicht der noch nicht geschlossenen Einrichtung von einer Längsseite, und zwar im dargestellten Beispiel mit der Halbschale 2 im Vordergrund. Hieraus geht die Form der Rastvorsprünge hervor. Die Rastvorsprünge enthalten einen Schaft 21, der senkrecht aus der Längskante 12 vorspringt. Am Ende des geradlinigen Schafts 21 ist eine federnde Zunge 22 angeformt, die unter einem spitzen Winkel gegenüber dem Schaft 21 verläuft und zurück auf die Längskante 12 der zugehörigen Halbschale 2 zeigt.

Die beiden Rastvorsprünge 13 sind spiegelbildlich zueinander ausgebildet.

Klappt man nun die beiden Halbschalen 1, 2 zusammen, so sieht die Einrichtung so aus, wie dies in Figur 7 dargestellt ist. Die unter Bezugnahme auf die Figur 1 bereits erwähnte Durchbrechung 15 ist an der Stelle der Halbschale 1 vorhanden, an der die Rastvorsprünge 13 der Halbschale 2 zu liegen kommen. Durch die Durchbrechung 15 ist also das zusammenwirken der Rastvorsprünge 13 mit einem Gegenelement in der Ausnehmung 14 zu sehen.

Oberhalb dieser Durchbrechung weist die Seitenwand der Halbschale 1 jeweils eine Öffnung 23 auf, die aufgrund der abgerundeten Form der Halbschale 1 auch leicht bogenförmig verläuft.

Die Figur 8 zeigt nun in vergrößertem Maßstab einen Ausschnitt aus der Figur 7, nämlich eine Durchbrechung 15. In dieser Durchbrechung 15 ist die federnde Zunge 22 zu sehen, die an dem Rastvorsprung 13 angeformt ist. Die Durchbrechung 15 ist in der Halbschale 1 ausgebildet, in der die Vertiefung 14 zur Aufnahme des Schafts 21 des Rastvorsprungs 13 ausgebildet ist. In der Vertiefung 14 ist eine Schulter 24 gebildet, hinter die das Stirnende der federnden Zunge 22 einrastet, wenn die Verriegelungseinrichtung geschlossen ist. Auf der gegenüberliegenden Seite der Rastschulter 24 ist eine Schrägfläche 25 gebildet, die beim Zusammenklappen des Gehäuses dazu führt, dass die federnde Zunge 22 an dieser Schrägfläche 25 abgleitet.

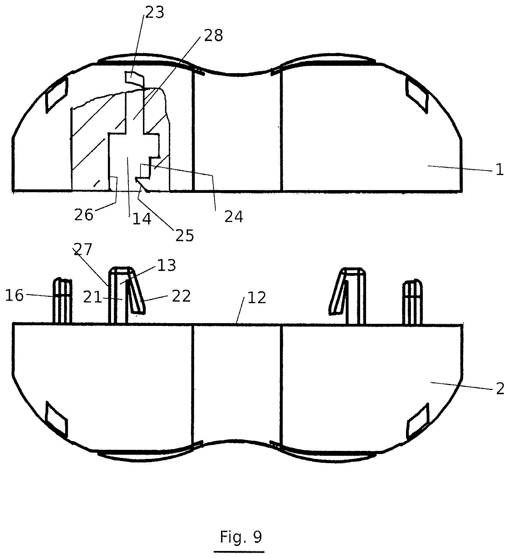

Die Figur 9 zeigt in einer schematischen Darstellung das Zusammenwirken eines Rastvorsprungs 13 mit der Rastschulter 24. Zu diesem Zweck sind die beiden Halbschalen 1, 2 einander gegenüberliegend aber mit Abstand angeordnet dargestellt. Die Halbschale 1 mit der Vertiefung 14 ist aufgebrochen dargestellt, wobei der Schnitt durch die Vertiefung 14 gelegt ist, so dass die Durchbrechung 15 hier nicht zu sehen ist. Die Vertiefung 14 ist so ausgebildet, dass sie angenähert der Form des Rastvorsprungs 13 entspricht. Die linke Begrenzungswand 26 der Vertiefung 14 ist an der gleichen Stelle angeordnet wie der linke Rand 27 des Schafts 21 des Rastvorsprungs 13. Dadurch ist der Rastvorsprung 13 in der Vertiefung 14 geführt. Beim Einschieben klappt die federnde Zunge 22 in Richtung auf den Schaft 21, bis ihr Stirnende an der Kante zwischen der Schrägfläche 25 und der Schulter 24 vorbei gelangt ist. Dann klappt die federnde Zunge 22 wieder nach außen, und ihre Stirnfläche liegt auf der Schulter 24 an.

Sowohl die korrekte Anordnung der federnden Zunge 22, wie sie in Figur 8 dargestellt ist, als auch eine nicht korrekte Anordnung können durch die Durchbrechung 15 erkannt werden. Die Zunge 22 bewegt sich bei ihrem Übergang von der noch nicht durchgeführten Verriegelung zu der korrekten Verriegelung in der Ebene der Durchbrechung, also von links nach rechts. Beide miteinander zusammenwirkenden Verriegelungsflächen, nämlich die Schulter 24 und das Stirnende der Zunge 22, sind in der Durchbrechung 15 zu sehen.

Der Verlauf der federnden Zunge 22 ist also ebenso wie die Anordnung ihrer Stirnfläche ein Erkennungszeichen dafür, dass die Verriegelungseinrichtung korrekt verriegelt ist. Diese Linien können mithilfe einer optischen Erkennungseinrichtung erkannt werden. Hierzu ist diese Durchbrechung 15 in der Außenseite der einen Halbschale 1 vorgesehen.

Die Vertiefung 14 geht über einen schematisch angedeuteten Kanal 28 in die nur angedeutete Öffnung 23 über, durch die ein Werkzeug eingesetzt werden kann. Der Kanal 28 fluchtet mit der federnden Zunge 22. Wenn auf die federnde Zunge 22 von oben in Figur 8 oder Figur 9 her eine Kraft ausgeübt wird, verschwenkt sie sich in Richtung auf den Schaft 21 des Rastvorsprungs 13, so dass der Rastvorsprung 13 wieder an der Schulter 24 vorbei aus der Vertiefung 14 heraus bewegt werden kann.

Die Figur 10 zeigt eine Stirnansicht der Einrichtung in geschlossenem Zustand. Hier ist die Zuordnung der beiden Stege 16 zu der durch die beiden Aussparungen 3 gebildeten Öffnung zu sehen. Der Abstand der Innenkanten der beiden Stege 16 ist also kleiner als der Durchmesser der Öffnung. Mithilfe der beiden Stege lässt sich die noch geöffnete Einrichtung an einem Kabel festlegen. Das Kabel wird zwischen den beiden Stegen 16 verklemmt. Die Stege 16 können in gewissem Maße auch ausweichen oder nachgeben.

Die Figur 11 zeigt eine Ansicht des zusammengeklappten Gehäuses von oben in Figur 7. Hier sind ebenfalls die beiden Öffnungen 23 für das Werkzeug zum Entriegeln des Gehäuses sichtbar.

## Patentansprüche

1. Einrichtung zum Absorbieren des elektrischen Rauschens, mit einem Gehäuse, das zwei Gehäusehalbschalen (1, 2) zur Aufnahme je eines Elements (7) aus einem Rauschen verhindernden Material und
in geschlossenem Zustand in seinen beiden Stirnwänden je eine Durchgangsöffnung (3, 3) für ein oder mehrere Kabel aufweist,
in jeder Gehäusehalbschale (1, 2) einem Element (7) aus dem das Rauschen verhindernden Material, wobei
die beiden Elemente (7) jeweils eine halbzylindrische in zusammengesetztem Zustand des Gehäuses einen im wesentlichen geschlossenen zylindrischen Durchgang für das/die Kabel bildende Nut (8) aufweisen,
sowie mit einer Verriegelungseinrichtung, die zwei zur Verriegelung miteinander zusammenwirkende Teile (13/22, 14/24/25) aufweist und innerhalb der Wand einer der Halbschalen (1) wirksam ist,
**gekennzeichnet dadurch, dass** die Verriegelungseinrichtung durch eine Durchbrechung (15) der Wand dieser Gehäusehalbschale (1) derart sichtbar ist, dass
durch die Durchbrechung (15) die beiden miteinander zusammenwirkende Teile der Verriegelungseinrichtung optisch überprüft werden können und
sowohl die korrekt verriegelte als auch die nicht korrekt verriegelte Anordnung der Verriegelungseinrichtung durch die Durchbrechung (15) unterscheidbar erkennbar sind.

2. Einrichtung nach Anspruch 1, bei der die Verriegelungseinrichtung derart ausgebildet ist, dass sie beim Schließen des Gehäuses durch den Schließvorgang betätigt wird.

3. Einrichtung nach Anspruch 1 oder 2, mit mindestens einem an einer Längskante (12) der einen Gehäusehalbschale (2) angeordneten Rastvorsprung (13) und einer an der anderen Gehäusehalbschale (1) angeordneten Rastschulter (24), hinter die in korrekt geschlossenem Zustand des Gehäuses der Rastvorsprung (13) eingreift.

4. Einrichtung nach Anspruch 3, bei der die Rastschulter (24) in einer in der Längskante (12) der Halbschale (1) mündenden Vertiefung (14) angeordnet ist, die eine Führung für den Rastvorsprung (13) bildet.

5. Einrichtung nach einem der vorhergehenden Ansprüche, bei der die Verriegelungseinrichtung eine in der Oberfläche einer der Halbschalen (1) mündende Öffnung (23) zum Einsetzen eines die Verriegelungseinrichtung außer Eingriff bringenden Werkzeugs aufweist.

6. Einrichtung nach einem der vorhergehenden Ansprüche, bei der die Verriegelungseinrichtung an zwei in Längsrichtung des Gehäuses einen Abstand aufweisenden Stellen wirksam ist.

7. Einrichtung nach einem der vorhergehenden Ansprüche, bei der die beiden Gehäusehalbschalen (1, 2) an ihrer einen Längskante (5) mithilfe eines Filmscharniers (6) miteinander verbunden sind.

8. Einrichtung nach einem der vorhergehenden Ansprüche, mit einer Einrichtung zur Fixierung einer Gehäusehalbschale (2) an einem durch das Gehäuse geführten Kabel auch in geöffnetem Zustand des Gehäuses.

9. Einrichtung nach einem der vorhergehenden Ansprüche, mit einer Halterung zur Festlegung eines Ferritelements (7) in der jeweiligen Halbschale (1, 2).

10. Einrichtung nach einem der vorhergehenden Ansprüche, bei der die Verriegelungseinrichtung derart ausgebildet ist, dass mindestens eines der die Verriegelungseinrichtung bildenden Teile (22, 24) beim Übergang aus der nicht verriegelten Position in die Verriegelungsposition eine in einer Ebene parallel zur Ebene der Durchbrechung (15) liegende Bewegung ausführt.

## Claims

1. Device for absorption of electrical noise, having
a housing,
which comprises two housing half-shells (1, 2) for receiving in each case one element (7) made of a noise-preventing material, and
in the closed state in both end face walls thereof in each case one passage opening (3, 3) for one or multiple cables,
in each housing half-shell (1, 2) an element (7) made of the noise-preventing material, wherein
the two elements (7) comprise in each case a semi-cylindrical groove (8) forming an essentially closed cylindrical passage for the cable/cables in the assembled state of the housing,
and having a locking device which includes two parts (13/22, 14/24/25) cooperating for locking and is operative inside the wall of one of the half-shells (1),
**characterized in that**
the locking device is visible through an aperture (15) of the wall of said housing half-shell (1) such that through the aperture (15) an optical checking of the two parts of the locking device mutually acting together is allowed, and
both the correctly locked and the not correctly locked arrangement of the locking device can be detected distinctly through the aperture (15).

2. Device according to claim 1, wherein the locking device is configured such that it is actuated during closing of the housing by means of the closing procedure.

3. Device according to claim 1 or 2, having at least one snap protrusion (13) arranged on a longitudinal edge (12) of one housing half-shell (2) and a snap shoulder (24) arranged on the other housing half-shell (1), behind which shoulder the snap protrusion (13) engages in the correctly closed state of the housing.

4. Device according to claim 3, wherein the snap shoulder (24) is arranged in a depression (14) ending in the longitudinal edge (12) of the half-shell (1), which depression forms a guidance for the snap protrusion (13).

5. Device according to any of the preceding claims, wherein for insertion of a tool disengaging the locking device, the locking device comprises an opening (23) ending in the surface of one of the half-shells (1).

6. Device according to any of the preceding claims, wherein the locking device is operative on two locations spaced in the longitudinal direction of the housing.

7. Device according to any of the preceding claims, wherein the two housing half-shells (1, 2) are connected to one another on one of their longitudinal edges (5) by means of a film hinge (6).

8. Device according to any of the preceding claims, including a device for fixing a housing half-shell (2) to a cable guided through the housing even in the opened state of the housing.

9. Device according to any of the preceding claims, including a support for fixing a ferrite element (7) in the respective half-shell (1, 2).

10. Device according to any of the preceding claims, wherein the locking device is configured such that at least one of the parts (22, 24) forming the locking device performs a movement within a plane in parallel to the plane of the aperture (15) during transfer from the not locked position into the locking position.

## Revendications

1. Dispositif pour absorber le bruit de fond électrique, comprenant un boîtier
qui possède deux demi-coques de boîtier (1, 2) destinées à accueillir chacune un élément (7) en un matériau empêchant le bruit de fond et
à l'état fermé, respectivement une ouverture de passage (3, 3) pour un ou plusieurs câbles dans ses deux parois frontales,
comprenant dans chaque demi-coque de boîtier (1, 2) un élément (7) en le matériau empêchant le bruit de fond, les deux éléments (7) possédant respectivement une rainure (8) demi-cylindrique qui, dans l'état assemblé du boîtier, forme un passage cylindrique sensiblement fermé pour le/les câble(s),
et comprenant également un dispositif de verrouillage qui
possède deux parties (13/22, 14/24/25) qui coopèrent entre elles pour le verrouillage et
qui agit à l'intérieur de la paroi de l'une des demi-coques (1),
**caractérisé en ce que** le dispositif de verrouillage est visible à travers une percée (15) de la paroi de cette demi-coque de boîtier (1) de telle sorte que les deux parties qui coopèrent entre elles du dispositif de verrouillage peuvent être contrôlées visuellement à travers la percée (15) et l'arrangement correctement verrouillé et aussi incorrectement verrouillé du dispositif de verrouillage peut être reconnu de manière distinctive à travers la percée (15).

2. Dispositif selon la revendication 1, avec lequel le dispositif de verrouillage est configuré de telle sorte qu'il est actionné par l'opération de fermeture lors de la fermeture du boîtier.

3. Dispositif selon la revendication 1 ou 2, comprenant au moins une saillie d'encliquetage (13) disposée sur une arrête longitudinale (12) d'une demi-coque de boîtier (2) et un épaulement d'encliquetage (24) disposé sur l'autre demie-coque de boîtier (1), derrière lequel vient en prise la saillie d'encliquetage (13) dans l'état correctement fermé du boîtier.

4. Dispositif selon la revendication 3, avec lequel l'épaulement d'encliquetage (24) est disposé dans une cavité (14) qui débouche dans l'arrête longitudinale (12) de la demi-coque (1) et qui forme un guide pour la saillie d'encliquetage (13).

5. Dispositif selon l'une des revendications précédentes, avec lequel le dispositif de verrouillage possède une ouverture (23) qui débouche dans la surface de l'une des demi-coques (1) et qui sert à insérer un outil qui amène le dispositif de verrouillage hors prise.

6. Dispositif selon l'une des revendications précédentes, avec lequel le dispositif de verrouillage est actif au niveau de deux endroits qui présentent un écart dans le sens longitudinal du boîtier.

7. Dispositif selon l'une des revendications précédentes, avec lequel les deux demi-coques de boîtier (1, 2) sont reliées entre elles au niveau de l'une de leurs arrêtes longitudinales (5) à l'aide d'un film formant charnière (6).

8. Dispositif selon l'une des revendications précédentes, comprenant un dispositif destiné à fixer une demi-coque de boîtier (2) à un câble passant à travers le boîtier, même à l'état ouvert du boîtier.

9. Dispositif selon l'une des revendications précédentes, comprenant un support destiné à bloquer un élément en ferrite (7) dans la demi-coque (1, 2) respective.

10. Dispositif selon l'une des revendications précédentes, avec lequel le dispositif de verrouillage est configuré de telle sorte qu'au moins l'une des parties (22, 24) qui forment le dispositif de verrouillage, lors de la transition de la position non verrouillée à la position de verrouillage, effectue un mouvement qui se trouve dans un plan parallèle au plan de la percée (15).
